(19) Europäisches Patentamt / European Patent Office / Office européen des brevets

(11) **EP 4 318 008 B1**

(12) **EUROPEAN PATENT SPECIFICATION**

(45) Date of publication and mention
of the grant of the patent:
**03.12.2025 Bulletin 2025/49**

(21) Application number: **22890200.3**

(22) Date of filing: **12.10.2022**

(51) International Patent Classification (IPC):
**G01R 31/392** *(2019.01)* **G01R 31/389** *(2019.01)*
**G01R 27/08** *(2006.01)* **G01R 31/3842** *(2019.01)*
**G01R 19/165** *(2006.01)* **G01R 31/36** *(2020.01)*
**G01R 31/367** *(2019.01)* **G01R 31/396** *(2019.01)*

(52) Cooperative Patent Classification (CPC):
**G01R 31/389; G01R 31/392;** Y02E 60/10

(86) International application number:
**PCT/KR2022/015393**

(87) International publication number:
**WO 2023/080465 (11.05.2023 Gazette 2023/19)**

(54) **BATTERY DIAGNOSIS METHOD BASED ON DEGREE OF RESISTANCE DEGRADATION AND BATTERY SYSTEM APPLYING THE SAME**

BATTERIEDIAGNOSEVERFAHREN AUF BASIS DES GRADES DER WIDERSTANDSVERSCHLECHTERUNG UND BATTERIESYSTEM MIT DARAUF ANGEWANDTEM BATTERIEDIAGNOSEVERFAHREN

PROCÉDÉ DE DIAGNOSTIC DE BATTERIE BASÉ SUR UN DEGRÉ DE DÉGRADATION DE RÉSISTANCE ET SYSTÈME DE BATTERIE AUQUEL EST APPLIQUÉ UN PROCÉDÉ DE DIAGNOSTIC DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **02.11.2021 KR 20210149028**

(43) Date of publication of application:
**07.02.2024 Bulletin 2024/06**

(73) Proprietor: **LG ENERGY SOLUTION, LTD.**
**Seoul 07335 (KR)**

(72) Inventor: **HONG, Sung Ju**
**Daejeon 34122 (KR)**

(74) Representative: **Plasseraud IP**
**104 Rue de Richelieu**
**CS92104**
**75080 Paris Cedex 02 (FR)**

(56) References cited:
| | |
|---|---|
| EP-A1- 3 429 053 | WO-A1-2021/049753 |
| WO-A1-2021/118118 | JP-A- 2004 031 120 |
| JP-A- 2006 138 750 | JP-A- 2006 138 750 |
| JP-A- 2016 090 416 | JP-A- 2018 205 313 |
| JP-A- 2018 205 313 | KR-A- 20160 085 529 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Cross-reference to related application

This application claims priority to and the benefit of Korean Patent Application No. 10-2021-0149028 filed in the Korean Intellectual Property Office on November 2, 2021.

## [Technical Field]

The present invention relates to a battery diagnosis method based on a degree of resistance degradation and a battery system applying the battery diagnosis method.

## [Background Art]

A battery pack may include a plurality of battery banks connected in series, and each battery bank may include a plurality of battery cells connected in parallel.

When the battery pack is repeatedly charged and discharged through an external device, a difference in the charging capacity of an internal battery cell may occur. When charging and discharging are continued while leaving the difference unattended, a resistance degradation or an abnormal situation of the battery cell may occur.

When the resistance degradation or the abnormal situation of the battery cell occurs, there may be a problem in that the battery pack cannot stably supply power to an external device.

Document JP4606846 relates to a battery monitoring device for monitoring a state of a secondary battery block for detecting an abnormality of a cell constituting the secondary battery block. The document JP2006138750 discloses a method of diagnosing a battery pack according to the state of the **art.**

## [Disclosure]

## [Technical Problem]

The present invention has been made in an effort to provide a battery diagnosis method capable of detecting an abnormality in each of a plurality of battery banks with respect to a battery pack including the plurality of battery banks, and a battery system applying the battery diagnosis method.

## [Technical Solution]

A battery diagnosis method according to an embodiment of the present invention is defined in the appended claims.

A battery system according to another embodiment of the present invention is also provided.

## [Advantageous Effects]

With respect to a battery pack including a plurality of battery banks, each of the plurality of battery banks may be discharged under a certain condition, a voltage variation may be derived before and after the discharging of the each of the plurality of battery banks, the degree of resistance degradation of each of the plurality of battery banks may be calculated based on the voltage variation, and an abnormality in each of the plurality of battery banks may be detected based on the degree of resistance degradation of each of the plurality of battery banks.

## [Description of the Drawings]

FIG. 1 is a diagram illustrating a battery system according to an embodiment.
FIG. 2 is a flowchart illustrating a battery diagnosis method according to an embodiment.
FIG. 3 is waveform diagrams illustrating changes in a switch control signal, a bank voltage, and a bank current according to discharging of each of a plurality of battery banks.
FIG. 4 is a detailed flowchart for explaining operations of diagnosing a plurality of battery banks based on a plurality of degrees of resistance degradation.

EP 4 318 008 B1

**[Mode for Invention]**

Hereinafter, the embodiments disclosed in the present specification will be described in detail with reference to the accompanying drawings, but same or similar components are given the same or similar reference numerals, and redundant descriptions thereof will be omitted. The suffixes "module" and/or "part" for components used in the following description are given or mixed in consideration of only the ease of drafting the specification, and do not have meanings or roles distinct from each other by themselves. In addition, in describing the embodiments disclosed in the present specification, when it is determined that detailed descriptions of related known technologies may obscure the gist of the embodiments disclosed in the present specification, the detailed description thereof will be omitted. In addition, the accompanying drawings are only for easy understanding of the embodiments disclosed in the present specification, do not limit the technical idea disclosed in the present specification, and should be understood to include all changes, equivalents or substitutes included in the spirit and scope of the present disclosure.

The terms including an ordinal number, such as first, second, etc., may be used to describe various components, but the components are not limited by the terms. These terms are used only for the purpose of distinguishing one component from another.

It will be further understood that the terms "comprises" and/or "comprising," when used in the present specification, specify the presence of stated features, integers, steps, operations, components, and/or parts, but do not preclude the presence or addition of one or more other features, integers, steps, operations, components, parts, and/or combinations thereof.

A program implemented as a set of instructions embodying a control algorithm necessary to control another configuration may be installed in a configuration controlling another configuration under a specific control condition among configurations according to an embodiment. The control configuration may process input data and stored data according to the installed program to generate output data. The control configuration may include a non-volatile memory to store a program and a memory to store data.

Hereinafter, a method of estimating a degree of resistance degradation of a battery bank and diagnosing a battery in consideration of a multi-parallel ideality factor of the degree of resistance degradation and a battery system applying the method according to an embodiment will be described with reference to the drawings. The method of diagnosing the battery in consideration of the multi-parallel ideality factor of the degree of resistance degradation may be implemented as software installed in a battery management system or a program including a combination of software. The corresponding program may be stored in a storage medium of the battery management system. The storage medium may be implemented as various types of memory, such as high-speed random access memory, flash memory device, non-volatile memory such as other non-volatile solid-state memory device, etc.

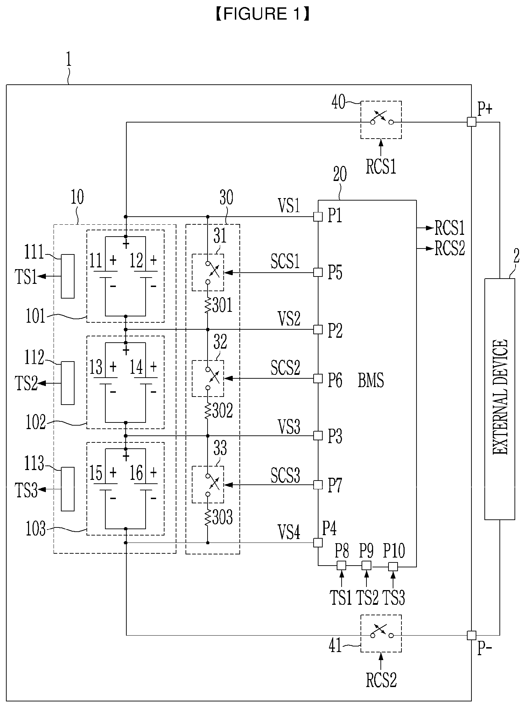

FIG. 1 is a diagram illustrating a battery system according to an embodiment.

A battery system 1 includes a battery pack 10, a battery management system 20, a discharge circuit 30, and relays 40 and 41. Hereinafter, the battery management system 20 is referred to as a BMS. FIG. 1 shows that the number of battery pack 10 is one, but the invention is not limited thereto, and the battery system 1 may include two or more battery packs.

An external device 2 may include a load such as an inverter and a converter and a charging device. When the external device 2 is a charger, both ends (such as P+ and P- in Fig. 1) of the battery system 1 may be connected to the charger, receive power from the charger, and charged. When the external device 2 is a load, both ends of the battery system 1 may be connected to the load so that power supplied by the battery pack 10 may be discharged through the load.

The battery pack 10 includes a plurality of battery banks 101 to 103 and a plurality of temperature sensors 111 to 113. FIG. 1 shows that the number of battery banks is three, but the invention is not limited thereto, and the battery pack 10 may include two or more battery banks.

Each (e.g., 101) of the plurality of battery banks 101 to 103 includes a plurality of battery cells (e.g., 11 and 12) connected in parallel. FIG. 1 shows that each battery bank (e.g., 101) includes two battery cells (e.g., 11 and 12) connected in parallel, but the invention is not limited thereto, and each battery bank may include two or more battery cells connected in parallel.

Each (e.g., 111) of the plurality of temperature sensors 111 to 113 may detect a bank temperature of the corresponding battery bank (e.g., 101) among the plurality of battery banks 101 to 103 and generate a temperature measurement signal (e.g., TS1). FIG. 1 shows that the plurality of temperature sensors 111 to 113 are positioned to respectively correspond to the plurality of battery banks 101 to 103 and generate the plurality of temperature measurement signals TS1 to TS3, but the invention is limited thereto, and the number and positions of the temperature sensors in the battery pack 10 may be changed.

The BMS 20 may monitor bank voltages and bank temperatures of the plurality of battery banks 101 to 103 from the plurality of voltage measurement signals and the plurality of temperature measurement signals, estimate degrees of resistance degradation of the battery banks by determining whether the battery banks satisfy discharge conditions based on the bank voltages, the bank temperatures, and a rest time, and diagnose the battery banks by detecting an abnormality of each battery bank based on the degree of resistance degradation for each battery bank.

The BMS 20 is connected to each of the plurality of battery banks 101 to 103, and obtains a plurality of voltage measurement signals VS1 to VS4 measured from both ends of the plurality of battery banks 101 to 103 through a plurality of input terminals P1 to P4. A positive electrode of each (e.g., 101) of the plurality of battery banks 101 to 103 is connected to the corresponding input terminal (e.g., P1) among the plurality of input terminals P1 to P3 through a wiring, and a negative electrode of each (e.g., 101) of the plurality of battery banks 101 to 103 is connected to the corresponding input terminal (e.g., P2) among the plurality of input terminals P2 to P4 through a wiring. For example, the measurement signal VS1 is the positive voltage of the battery bank 101 and is input to the BMS 20 through the input terminal P1, and the measurement signal VS2 is the voltage of the negative electrode of the battery bank 101 or the voltage of the positive electrode of the battery bank 102 and is input to the BMS 20 through the input terminal P2.

The BMS 20 may receive the plurality of temperature measurement signals TS1 to TS3 determined according to the temperatures respectively sensed from the plurality of temperature sensors 111 to 113 through a plurality of input terminals P8 to P10.

The discharge circuit 30 may include a plurality of discharge switches 31 to 33 and a plurality of discharge resistors 301 to 303. The discharge switch 31 and the discharge resistor 301 connected in series are connected in parallel between the positive electrode and the negative electrode of the battery bank 101, the discharge switch 32 and the discharge resistor 302 connected in series are connected in parallel between the positive electrode and the negative electrode of the battery bank 102, and the discharge switch 33 and the discharge resistor 303 connected in series are connected in parallel between the positive electrode and the negative electrode of the battery bank 103. The number of the plurality of discharge switches 31 to 33 and the plurality of discharge resistors 301 to 303 may increase or decrease according to the number of the plurality of battery banks 101 to 103.

On and off of the plurality of discharge switches 31 to 33 may be controlled according to switch control signals SCS1 to SCS3 supplied from the BMS 20. Each (e.g., SCS1) of the plurality of switch control signals SCS1 to SCS3 is transmitted to the corresponding switch 31 among the plurality of discharge switches 31 to 33 through the corresponding output terminal (e.g., P5) among a plurality of output terminals P5 to P7 of the BMS 20.

Each (e.g., 301) of the plurality of discharge resistors 301 to 303 discharges the corresponding battery bank (e.g., 101) among the plurality of battery banks 101 to 103 when the corresponding discharge switch (e.g., 31) among the plurality of discharge switches 31 to33 is turned on.

One end of each of the relays 40 and 41 is connected to the battery pack 10, and the other end of each of the relays 40 and 41 is connected to at least one component in the external device 2. The closing and opening of the relays 40 and 41 are controlled according to relay control signals RCS1 and RCS2 supplied from the BMS 20.

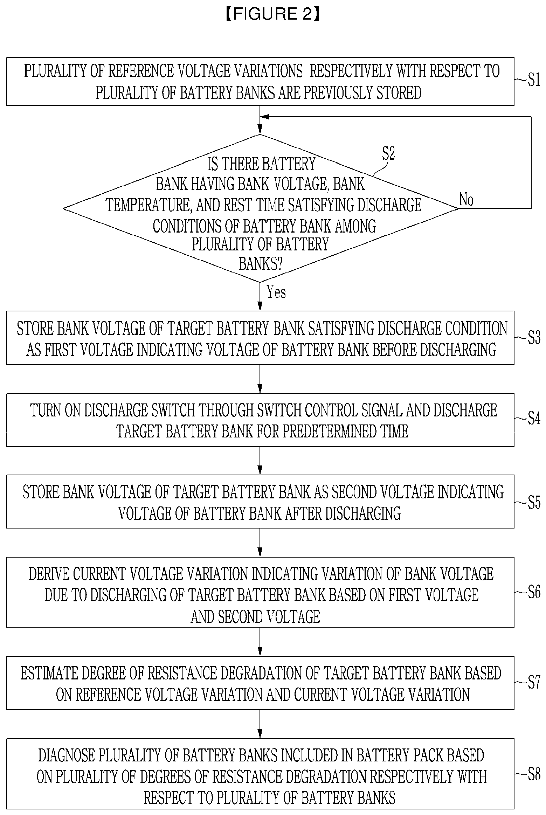

Hereinafter, the operation of each component of the BMS 20 for diagnosing the state of the battery pack 10 will be sequentially described according to the flowchart shown in FIG. 2.

FIG. 2 is a flowchart illustrating a battery diagnosis method according to an embodiment.

In the BMS 20, a plurality of reference voltage variations ($\Delta V_{reference}$) are previously stored respectively with respect to the plurality of battery banks 101 to 103 (S1).

A voltage variation will be described below in step S6 of calculating the voltage variation. A reference voltage variation may be an initial voltage variation. The initial voltage variation may mean a voltage variation before and after discharging when each of the plurality of battery banks 101 to 103 is initially discharged.

The BMS 20 determines whether there is a battery bank having a bank voltage, a bank temperature, and a rest time satisfying discharge conditions among the plurality of battery banks 101 to 103 (S2).

Hereinafter, the battery bank having the bank voltage, the bank temperature, and the rest time satisfying the discharge conditions among the plurality of battery banks 101 to 103 is referred to as a target battery bank. The BMS 20 may detect the target battery bank based on the bank voltage, the bank temperature, and the rest time of each of the plurality of battery banks 101 to 103.

The BMS 20 may derive a plurality of bank voltages respectively with respect to the plurality of battery banks 101 to 103 based on the plurality of voltage measurement signals VS1 to VS4. For example, the BMS 20 may derive a bank voltage of the battery bank 101 based on a voltage difference between the voltage measurement signal VS1 and the voltage measurement signal VS2. The BMS 20 may derive the same number of bank voltages as the number of battery banks 101 to 103 included in the battery pack 10.

The BMS 20 may derive a plurality of bank temperatures respectively with respect to the plurality of battery banks 101 to 103 based on the plurality of temperature measurement signals TS1 to TS3. The BMS 20 may derive the same number of bank temperatures as the number of battery banks 101 to 103 included in the battery pack 10. FIG. 1 shows that three temperature sensors are positioned to respectively correspond to the plurality of battery banks 101 to 103, but the battery pack 10 may include a smaller number of temperature sensors than the number of the plurality of battery banks. In this case, the BMS 20 may estimate the bank temperature of each of the plurality of battery banks 101 to 103 from the temperature measurement signal sensed by each of the temperature sensors.

The BMS 20 may determine whether a rest time during which the battery bank is not charged/discharged satisfies a condition regarding the rest time included in the discharge conditions.

The discharge conditions may include conditions related to at least the bank voltage, the bank temperature, and the rest time. For example, the discharge conditions may include conditions that the bank voltage is in the range of 3.6 V to 3.65 V, the bank temperature is in the range of 20 °C to 30 °C, and the rest time is equal to or greater than 2 hours.

The BMS 20 may periodically repeat step S2 when there is no battery bank having the bank voltage, the bank temperature, and the rest time satisfying the discharge conditions among the plurality of battery banks 101 to 103.

When there is the target battery bank having the bank voltage, the bank temperature, and the rest time satisfying the discharge conditions among the plurality of battery banks 101 to 103, the BMS 20 may store the bank voltage of the target battery bank as a first voltage indicating the voltage of the battery bank before discharging (S3).

Hereinafter, it will be described that the battery bank 101 is the target battery bank satisfying the discharge conditions.

The BMS 20 may derive a bank voltage VB1 of the target battery bank 101 before discharging of the target battery bank 101 starts, and store the derived bank voltage VB1 as the first voltage.

The BMS 20 may turn on the discharge switch 31 through the switch control signal SCS1 and discharge the target battery bank 101 for a predetermined time (S4).

Each (e.g., 31) of the plurality of discharge switches 31 to 33 is turned on when the corresponding switch control signal (e.g., SCS1) among the plurality of switch control signals SCS1 to SCS3 is at a high level that is an on level and is turned off when it is at a low level that is an off level. For example, when the switch control signal SCS1 is at a high level, the discharge switch 31 may be turned on.

The predetermined time may be a fixed time previously determined as initial information.

When the discharging of the target battery bank 101 ends after the predetermined time elapses, the BMS 20 may store the bank voltage of the target battery bank as a second voltage indicating the voltage of the battery bank after discharging (S5).

After the discharging of the target battery bank 101 ends, the BMS 20 may derive the bank voltage VB1 of the target battery bank 101 and store the derived bank voltage VB1 as the second voltage.

The BMS 20 may derive a current voltage variation ($\Delta V_{current}$) indicating the variation of the bank voltage due to the discharging of the target battery bank 101 based on the first voltage and the second voltage (S6).

Referring to [Equation 1], the current voltage variation ($\Delta V_{current}$) may be derived based on the first voltage and the second voltage.

## [Equation 1]

$$\Delta V_{current} = V2 - V1$$

$\Delta V_{current}$ indicates the current voltage variation of the battery bank, V1 indicates the voltage stored as the first voltage, and V2 indicates the voltage stored as the second voltage.

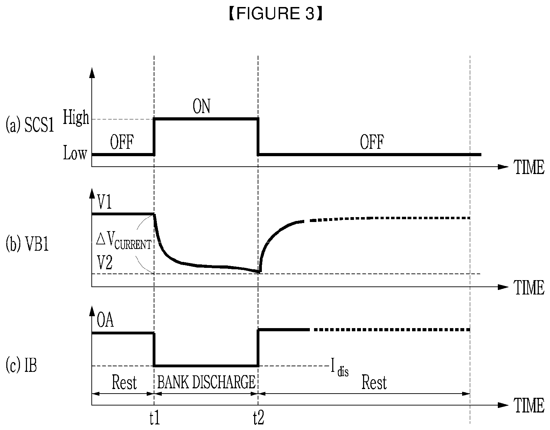

Hereinafter, a process in which the BMS 20 derives the current voltage variation of the target battery bank 101 will be described with reference to FIG. 3.

FIG. 3 is waveform diagrams illustrating changes in a switch control signal, a bank voltage, and a bank current according to discharging of a battery bank.

As shown in FIG. 3, the bank voltage VB1 of the target battery bank 101 may be reduced by discharging. In FIG. 3, the waveform diagram (a) shows the switch control signal SCS1 corresponding to the target battery bank 101 among the plurality of switch control signals SCS1 to SCS3, the waveform diagram (b) shows the bank voltage VB1 of the target battery bank 101 over time, and the waveform diagram (c) shows a bank current IB flowing in the target battery bank 101 over time.

According to the waveform diagrams shown in FIG. 3, the discharging switch 31 may be turned on by a signal of a high level that is an on level of the switch control signal SCS1.

The switch control signal SCS1 may be maintained as a signal of a low level that is an off level, may transition to a signal of a high level at a time t1, and may be maintained at a high level until a time t2. Thereafter, the switch control signal SCS1 may transition to a signal of a low level from the time t2 again and may be maintained.

Referring to FIG. 3, the BMS 20 may derive the bank voltage VB1 in synchronization with the time t1 at which discharging of the target battery bank 101 starts. The bank voltage VB1 derived at the time t1 is the voltage V1.

The BMS 20 may derive the bank voltage VB1 in synchronization with the time t2 at which discharging of the target battery bank 101 ends. The bank voltage VB1 derived at the time t2 is the voltage V2. The BMS 20 may calculate a difference (V2-V1) between the bank voltage at the time t1 and the bank voltage at the time t2, and calculate the current voltage variation ($\Delta V_{current}$) of the bank voltage VB1 due to the discharging of the target battery bank 101.

During discharging, the bank current IB may be constantly controlled to a current level $I_{dis}$.

The BMS 20 may estimate a degree of resistance degradation of the target battery bank 101 based on the reference voltage variation ($\Delta V_{reference}$) and the current voltage variation ($\Delta V_{current}$) (S7).

A degree of the increase in the resistance of the battery bank due to the increase in the internal resistance of the battery cell is referred to as the degree of resistance degradation.

The BMS 20 may estimate the degree of resistance degradation of the target battery bank 101 based on the reference voltage variation ($\Delta V_{reference}$) of the target battery bank 101 and the current voltage variation ($\Delta V_{current}$) of the target battery bank 101 among a plurality of reference voltage variations respectively with respect to the previously stored plurality of battery banks 101 to 103.

Referring to [Equation 2], the degree of resistance degradation of the battery bank may be estimated by calculating the ratio of the current voltage variation with respect to the reference voltage variation.

[Equation 2]

$$\text{degree of resistance degradation} = \frac{\Delta V_{current}}{\Delta V_{reference}}$$

The BMS 20 may repeat steps S1 to S7 until degrees of resistance degradation of all of the plurality of battery banks 101 to 103 included in the battery pack 10 are estimated.

The BMS 20 may diagnose the plurality of battery banks 101 to 103 included in the battery pack 10 based on a plurality of degrees of resistance degradation respectively with respect to the plurality of battery banks 101 to 103 (S8).

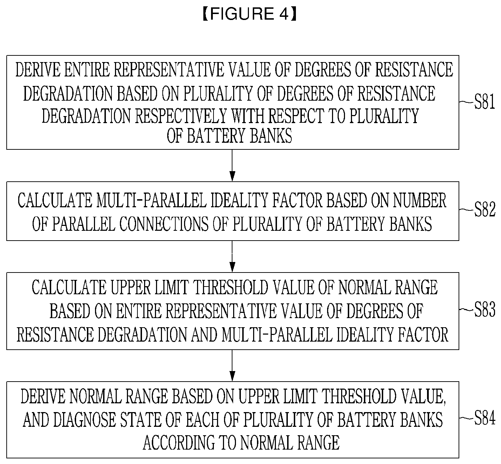

Hereinafter, a process in which the BMS 20 diagnoses the plurality of battery banks 101 to 103 based on the plurality of degrees of resistance degradation will be described with reference to FIG. 4.

FIG. 4 is a detailed flowchart for explaining a step of diagnosing a plurality of battery banks based on a plurality of degrees of resistance degradation.

The BMS 20 derives an entire representative value of the degrees of resistance degradation based on the plurality of degrees of resistance degradation respectively with respect to the plurality of battery banks 101 to 103 (S81).

As a method of deriving the entire representative value of the degrees of resistance degradation, a method of deriving a median value, an average value, etc. of the plurality of degrees of resistance degradation respectively with respect to the plurality of battery banks 101 to 103 may be used. Hereinafter, it will be described based on that the entire representative value of the degrees of resistance degradation is the median value of the plurality of degrees of resistance degradation.

The BMS 20 calculates a multi-parallel ideality factor based on the number of parallel connections of the plurality of battery banks 101 to 103 (S82).

The number of parallel connections is the number of a plurality of battery cells (e.g., 11 and 12) connected in parallel included in one (e.g., 101) of the plurality of battery banks 101 to 103.

As shown in FIG. 1, each of the plurality of battery banks 101 to 103 may have the same number of parallel connections.

In the example of FIG. 1, the plurality of battery banks 101 to 103 respectively include two battery cells 11-12, 13-14, and 15-16 connected in parallel, and the BMS 20 may determine two as the number of parallel connections of the plurality of battery banks 101 to 103.

Hereinafter, referring to [Equation 3], the BMS 20 may derive the multi-parallel ideality factor based on the number of parallel connections of the plurality of battery banks 101 to 103.

[Equation 3]

$$\mu = \frac{P}{P-1}$$

$\mu$ indicates the multi-parallel ideality factor. P indicates the number of parallel connections. In the example of FIG. 1, because the number of parallel connections is 2, $\mu$ is 2/1=2.

The BMS 20 may calculate the upper limit threshold value of a normal range based on the entire representative value of the degrees of resistance degradation and the multi-parallel ideality factor (S83).

When the plurality of battery banks 101 to 103 are in a normal state, a range with respect to the degree of resistance degradation of the battery bank is referred to as a normal range. A battery bank having a degree of resistance degradation that does not fall within the normal range may be determined to be in an abnormal state in which the battery bank has a high degree of resistance degradation.

First, the BMS 20 may set, as a target group, battery banks having a degree of resistance degradation equal to or less than the entire representative value among the plurality of degrees of resistance degradation respectively with respect to the plurality of battery banks 101 to 103.

The BMS 20 may derive a target representative value of the degree of resistance degradation of the battery banks belonging to the target group.

As a method of deriving the target representative value, a method of deriving a median value, an average value, etc. of degrees of resistance degradation of the battery banks belonging to the target group may be used. Hereinafter, it will be described based on that the target representative value of the degree of resistance degradation of the battery banks belonging to the target group is the median value of the degrees of resistance degradation respectively with respect to the plurality of battery banks belonging to the target group.

Hereinafter, referring to [Equation 4], the BMS 20 may calculate the upper limit threshold value by multiplying the target representative value derived as the median value of the degrees of resistance degradation respectively with respect to the plurality of battery banks belonging to the target group by the multi-parallel ideality factor.

[Equation 4]

$$\text{Upper} = X_T\big(T(B)\big) * (\mu) = X_T\big(T(B)\big) * \left(\frac{P}{P-1}\right)$$

Upper indicates the upper limit threshold value of the normal range. B indicates the degree of resistance degradation of the battery bank. T(B) indicates the degrees of resistance degradation of battery banks belonging to the target group. $X_T(T(B))$ indicates the target representative value of B. $\mu$ indicates the multi-parallel ideality factor. P indicates the number of parallel connections.

The BMS 20 may derive the normal range based on the upper limit threshold value, and diagnose the state of each of the plurality of battery banks 101 to 103 according to the normal range (S84).

The normal range may have the calculated upper limit threshold value.

When the normal range has the upper limit threshold value, the BMS 20 may determine a battery bank having a degree of resistance degradation equal to or less than the upper limit threshold value as a normal state. In addition, when the degree of resistance degradation of the battery bank exceeds the upper limit threshold value, the BMS 20 may determine that the battery bank is in an abnormal state.

The BMS 20 may diagnose the state of the battery pack 10 by distinguishing whether each of the plurality of battery banks 101 to 103 included in the battery pack 10 is in the normal state and/or whether each of the plurality of battery banks 101 to 103 is in the abnormal state.

While this invention has been described in connection with what is presently considered to be practical exemplary embodiments, it is to be understood that the invention is not limited to the disclosed embodiments. On the contrary, it is intended to cover various modifications and equivalent arrangements included within the scope of the appended claims.

## Claims

1. A method of diagnosing a battery pack (10) including a plurality of battery banks (101, ..., 103) each including a plurality of battery cells (11, ..., 16) connected in parallel, the method comprising:

   (a) determining (S2), by a battery management system (BMS), whether there is a target battery bank satisfying discharge conditions among the plurality of battery banks (101, ..., 103);
   (b) discharging (S4), by the BMS, the target battery bank detected through the determining for a predetermined time;
   (c) storing (S3, S5), by the BMS, a first bank voltage of the target battery bank before discharging the target battery bank and a second bank voltage of the target battery bank after discharging the target battery bank;
   (d) deriving (S6), by the BMS, a current voltage variation ($\Delta V_{current}$) based on the first bank voltage and the second bank voltage;
   (f) estimating (S7), by the BMS, a degree of resistance degradation with respect to the target battery bank based on a reference voltage variation ($\Delta V_{reference}$) of the target battery bank and the current voltage variation ($\Delta V_{current}$);
   (g) repeating steps (a) to (f) for each battery bank (101, ..., 103); and

(h) diagnosing (S8), by the BMS, the plurality of battery banks (101, ..., 103) based on the degree of resistance degradation with respect to each of the plurality of battery banks (101, ..., 103),
wherein the discharging conditions include at least one of a bank voltage, a bank temperature, and a rest time of each of the plurality of battery banks;
**characterized in that** the diagnosing of the plurality of battery banks (101, ..., 103) includes:

   deriving, by the BMS, an entire representative value of a plurality of degrees of resistance degradation based on the plurality of degrees of resistance degradation with respect to the plurality of battery banks (101, ..., 103);
   calculating, by the BMS, a multi-parallel ideality factor as the ratio between the number of parallel connections in the battery bank and the number of parallel connections minus one;
   calculating, by the BMS, an upper limit threshold value of a normal range by multiplying the entire representative value of the plurality of degrees of resistance degradation by the multi-parallel ideality factor; and
   deriving, by the BMS, the normal range based on the upper limit threshold value, and diagnosing a state of each of the plurality of battery banks (101, ..., 103) according to the normal range.

2. The method of claim 1, wherein the reference voltage variation ($\Delta V_{reference}$) of the target battery bank is an initial voltage variation stored in the BMS with respect to the target battery bank, and
   wherein the initial voltage variation is a voltage variation before and after a first discharge of each of the plurality of battery banks (101, ..., 103).

3. The method of claim 1, wherein the calculating of the upper limit threshold value includes:

   setting, by the BMS, as a target group, a plurality of first battery banks having a degree of resistance degradation less than or equal to the entire representative value of the plurality of degrees of resistance degradation among the plurality of battery banks (101, ..., 103);
   deriving, by the BMS, a target representative value of a plurality of degrees of resistance degradation of the plurality of first battery banks belonging to the target group; and
   calculating the upper limit threshold value of the normal range based on the target representative value and the multi-parallel ideality factor.

4. The method of claim 1, wherein the diagnosing of the state of each of the plurality of battery banks (101, ..., 103) includes:

   determining, by the BMS, a battery bank having a degree of resistance degradation equal to or less than the upper limit threshold value as the normal state among the plurality of battery banks (101, ..., 103); and
   determining, by the BMS, a battery bank having a degree of resistance degradation greater than the upper limit threshold value as an abnormal state among the plurality of battery banks (101, ..., 103).

5. A battery system comprising:

   a plurality of battery banks (101, ..., 103) in each of which a plurality of battery cells (11, ..., 16) are connected in parallel;
   a discharge circuit (30) connected in parallel between a positive electrode and a negative electrode of each of the plurality of battery banks (101, ..., 103) and configured to discharge each of the plurality of battery banks (101, ..., 103); and
   a battery management system (BMS) configured to:

      (a) determine (S2) whether there is a target battery bank satisfying discharge conditions among the plurality of battery banks (101, ..., 103);
      (b) discharge (S4) the target battery bank detected through the determining by the discharge circuit (30);
      (c) store (S3, S5) a first bank voltage of the target battery bank before discharging the target battery bank and a second bank voltage of the target battery bank after discharging the target battery bank;
      (d) derive (S6) a current voltage variation ($\Delta V_{current}$) based on the first bank voltage and the second bank voltage;
      (e) estimate (S7) a degree of resistance degradation with respect to the target battery bank based on a reference voltage variation ($\Delta V_{reference}$) of the target battery bank and the current voltage variation ($\Delta V_{current}$);

(g) repeat steps (a) to (f) for each battery bank; and

(h) diagnose the plurality of battery banks (101, ..., 103); based on the degree of resistance degradation with respect to each of the plurality of battery banks (101, ..., 103);,

wherein the discharging conditions include at least one of a bank voltage, a bank temperature, and a rest time of each of the plurality of battery banks;

**characterized in that** the BMS is configured to:

derive an entire representative value of a plurality of degrees of resistance degradation based on the plurality of degrees of resistance degradation with respect to the plurality of battery banks (101, ..., 103);

calculate a multi-parallel ideality factor as the ration between the number of parallel connections in the battery bank and the number of parallel connections minus one;

calculate an upper limit threshold value of a normal range by multiplying the entire representative value of the plurality of degrees of resistance degradation by the multi-parallel ideality factor; and

derive the normal range based on the upper limit threshold value, and diagnose a state of each of the plurality of battery banks (101, ..., 103) according to the normal range.

6. The battery system of claim 5, wherein the reference voltage variation ($\Delta V_{reference}$) of the target battery bank is an initial voltage variation stored in the BMS with respect to the target battery bank, and

wherein the initial voltage variation is a voltage variation before and after a first discharge of each of the plurality of battery banks.

7. The battery system of claim 6, wherein the BMS is configured to:

determine a battery bank having a degree of resistance degradation equal to or less than the upper limit threshold value of the degree of resistance degradation as the normal state among the plurality of battery banks (101, ..., 103); and

determine a battery bank having a degree of resistance degradation greater than the upper limit threshold value of the degree of resistance degradation as an abnormal state among the plurality of battery banks (101, ..., 103).

8. The battery system of claim 7, wherein the BMS is configured to diagnose a state of the plurality of battery banks (101, ..., 103) by distinguishing whether each of the plurality of battery banks (101, ..., 103) is in the abnormal state.

**Patentansprüche**

1. Verfahren zum Diagnostizieren eines Batteriepacks (10), umfassend eine Mehrzahl von Batteriebanken (101, ..., 103), wobei jede eine Mehrzahl von Batteriezellen (11, ..., 16) umfasst, welche parallel geschaltet sind, das Verfahren umfassend:

(a) Bestimmen (S2), durch ein Batterieverwaltungssystem (BMS), ob es eine Zielbatteriebank gibt, welche Entladebedingungen erfüllt, unter der Mehrzahl von Batteriebanken (101, ..., 103);

(b) Entladen (S4), durch das BMS, der Zielbatteriebank, welche durch das Bestimmen detektiert worden ist, für eine vorbestimmte Zeit;

(c) Speichern (S3, S5), durch das BMS, einer ersten Bankspannung der Zielbatteriebank, vor einem Entladen der Zielbatteriebank, und einer zweiten Bankspannung der Zielbatteriebank, nach einem Entladen die Zielbatteriebank;

(d) Ableiten (S6), durch das BMS, einer aktuellen Spannungsvariation ($\Delta V_{current}$) auf Grundlage der ersten Bankspannung und der zweiten Bankspannung;

(f) Schätzen (S7), durch das BMS, eines Grades einer Widerstandsverschlechterung in Bezug auf die Zielbatteriebank auf Grundlage einer Referenzspannungsvariation ($\Delta V_{reference}$) der Zielbatteriebank und der aktuellen Spannungsvariation ($\Delta V_{current}$);

(g) Wiederholen der Schritte (a) bis (f) für jede Batteriebank (101, ..., 103); und

(h) Diagnostizieren (S8), durch das BMS, der Mehrzahl von Batteriebanken (101, ..., 103) auf Grundlage des Grades einer Widerstandsverschlechterung in Bezug auf jede der Mehrzahl von Batteriebanken (101, ..., 103),

wobei die Entladebedingungen wenigstens eines aus einer Bankspannung, einer Banktemperatur und einer Ruhezeit jeder der Mehrzahl von Batteriebanken umfasst;

**dadurch gekennzeichnet, dass** das Diagnostizieren der Mehrzahl von Batteriebanken (101, ..., 103) umfasst:

Ableiten, durch das BMS, eines gesamten repräsentativen Wertes einer Mehrzahl von Graden einer Widerstandsverschlechterung auf Grundlage der Mehrzahl von Graden einer Widerstandsverschlechterung in Bezug auf die Mehrzahl von Batteriebanken (101, ..., 103);

Berechnen, durch das BMS, eines multiparallelen Idealitätsfaktors als das Verhältnis zwischen der Anzahl von parallelen Verbindungen in der Batteriebank und der Anzahl von parallelen Verbindungen minus eins;

Berechnen, durch das BMS, eines oberen Grenzschwellenwertes eines normalen Bereichs durch ein Multiplizieren des gesamten repräsentativen Wertes der Mehrzahl von Graden einer Widerstandsverschlechterung mit dem multiparallelen Idealitätsfaktor; und

Ableiten, durch das BMS, des normalen Bereichs auf Grundlage des oberen Grenzschwellenwertes und Diagnostizieren eines Zustands jeder der Mehrzahl von Batteriebanken (101, ..., 103) gemäß dem normalen Bereich.

2. Verfahren nach Anspruch 1, wobei die Referenzspannungsvariation ($\Delta V_{reference}$) der Zielbatteriebank eine initiale Spannungsvariation ist, welche in dem BMS gespeichert ist, in Bezug auf die Zielbatteriebank, und

wobei die initiale Spannungsvariation eine Spannungsvariation vor und nach einem ersten Entladen jeder der Mehrzahl von Batteriebanken (101, ..., 103) ist.

3. Verfahren nach Anspruch 1, wobei das Berechnen des oberen Grenzschwellenwertes umfasst:

Festsetzen, durch das BMS, als eine Zielgruppe, einer Mehrzahl von ersten Batteriebanken, welche einen Grad einer Widerstandsverschlechterung aufweisen, welcher gleich oder geringer als der gesamte repräsentative Wert der Mehrzahl von Graden einer Widerstandsverschlechterung ist, unter der Mehrzahl von Batteriebanken (101, ..., 103);

Ableiten, durch das BMS, eines repräsentativen Zielwertes einer Mehrzahl von Graden einer Widerstandsverschlechterung der Mehrzahl von ersten Batteriebanken, welche zu der Zielgruppe gehören; und

Berechnen des oberen Grenzschwellenwertes des normalen Bereichs auf Grundlage des repräsentativen Zielwertes und des multiparallelen Idealitätsfaktors.

4. Verfahren nach Anspruch 1, wobei das Diagnostizieren des Zustands jeder der Mehrzahl von Batteriebanken (101, ..., 103) umfasst:

Bestimmen, durch das BMS, einer Batteriebank, welche einen Grad einer Widerstandsverschlechterung gleich oder geringer als der obere Grenzschwellenwert aufweist, als den normalen Zustand unter der Mehrzahl von Batteriebanken (101, ..., 103); und

Bestimmen, durch das BMS, einer Batteriebank, welche einen Grad einer Widerstandsverschlechterung größer als den oberen Grenzschwellenwert aufweist, als einen anormalen Zustand unter der Mehrzahl von Batteriebanken (101, ..., 103).

5. Batteriesystem, umfassend:

eine Mehrzahl von Batteriebanken (101, ..., 103), in welcher jeweils eine Mehrzahl von Batteriezellen (11, ..., 16) parallel geschaltet sind;

eine Entladeschaltung (30), welche zwischen einer positiven Elektrode und einer negativen Elektrode von jeder der Mehrzahl von Batteriebanken (101, ..., 103) parallel geschaltet ist und dazu eingerichtet ist, jede der Mehrzahl von Batteriebanken (101, ..., 103) zu entladen; und

ein Batterieverwaltungssystem (BMS), welches eingerichtet ist, zum:

(a) Bestimmen (S2), ob es eine Zielbatteriebank gibt, welche Entladebedingungen erfüllt, unter der Mehrzahl von Batteriebanken (101, ..., 103);

(b) Entladen (S4) der Zielbatteriebank, welche durch das Bestimmen detektiert worden ist, durch die Entladeschaltung (30);

(c) Speichern (S3, S5) einer ersten Bankspannung der Zielbatteriebank, vor einem Entladen der Zielbatteriebank, und einer zweiten Bankspannung der Zielbatteriebank, nach einem Entladen der Zielbatteriebank;

(d) Ableiten (S6) einer aktuellen Spannungsvariation ($\Delta V_{current}$) auf Grundlage der ersten Bankspannung und der zweiten Bankspannung;

(e) Schätzen (S7) eines Grades einer Widerstandsverschlechterung in Bezug auf die Zielbatteriebank auf Grundlage einer Referenzspannungsvariation ($\Delta V_{reference}$) der Zielbatteriebank und der aktuellen Spannungsvariation ($\Delta V_{current}$);

(g) Wiederholen der Schritte (a) bis (f) für jede Batteriebank; und

(h) Diagnostizieren der Mehrzahl von Batteriebanken (101, ..., 103); auf Grundlage des Grades einer Widerstandsverschlechterung in Bezug auf jede der Mehrzahl von Batteriebanken (101, ..., 103),

wobei die Entladebedingungen wenigstens eines aus einer Bankspannung, einer Banktemperatur und einer Ruhezeit jeder der Mehrzahl von Batteriebanken umfassen;

**dadurch gekennzeichnet, dass** das BMS eingerichtet ist, zum:

Ableiten eines gesamten repräsentativen Wertes einer Mehrzahl von Graden einer Widerstandsverschlechterung auf Grundlage der Mehrzahl von Graden einer Widerstandsverschlechterung in Bezug auf die Mehrzahl von Batteriebanken (101, ..., 103);

Berechnen eines multiparallelen Idealitätsfaktors als das Verhältnis zwischen der Anzahl von parallelen Verbindungen in der Batteriebank und der Anzahl von parallelen Verbindungen minus eins;

Berechnen eines oberen Grenzschwellenwertes eines normalen Bereichs durch ein Multiplizieren des gesamten repräsentativen Wertes der Mehrzahl von Graden einer Widerstandsverschlechterung mit dem multiparallelen Idealitätsfaktors; und

Ableiten des normalen Bereichs auf Grundlage des oberen Grenzschwellenwertes und Diagnostizieren eines Zustands jeder der Mehrzahl von Batteriebanken (101, ..., 103) gemäß dem normalen Bereich.

6. Batteriesystem nach Anspruch 5, wobei die Referenzspannungsvariation ($\Delta V_{reference}$) der Zielbatteriebank eine initiale Spannungsvariation ist, welche in dem BMS gespeichert ist, in Bezug auf die Zielbatteriebank, und wobei die initiale Spannungsvariation eine Spannungsvariation vor und nach einem ersten Entladen jeder der Mehrzahl von Batteriebanken ist.

7. Batteriesystem nach Anspruch 6, wobei das BMS eingerichtet ist, zum:

Bestimmen einer Batteriebank, welche einen Grad einer Widerstandsverschlechterung gleich oder geringer als der obere Grenzschwellenwert des Grades einer Widerstandsverschlechterung aufweist, als den normalen Zustand unter der Mehrzahl von Batteriebanken (101, ..., 103); und

Bestimmen einer Batteriebank, welche einen Grad einer Widerstandsverschlechterung größer als den oberen Grenzschwellenwert des Grades einer Widerstandsverschlechterung aufweist, als einen anormalen Zustand unter der Mehrzahl von Batteriebanken (101, ..., 103).

8. Batteriesystem nach Anspruch 7, wobei das BMS dazu eingerichtet ist, einen Zustand der Mehrzahl von Batteriebanken (101, ..., 103) durch ein Unterscheiden zu diagnostizieren, ob sich jede der Mehrzahl von Batteriebanken (101, ..., 103) in dem anormalen Zustand befindet.

## Revendications

1. Procédé de diagnostic d'un bloc-batterie (10) comprenant une pluralité de bancs de batteries (101, ..., 103) comprenant chacun une pluralité d'éléments de batterie (11, ..., 16) connectés en parallèle, le procédé comprenant :

(a) le fait de déterminer (S2), par un système de gestion de la batterie (BMS), s'il y a un banc de batteries cible satisfaisant à des conditions de décharge parmi la pluralité de bancs de batteries (101, ..., 103) ;

(b) la décharge (S4), par le BMS, du banc de batteries cible détecté par l'intermédiaire de la détermination pendant un temps prédéterminé ;

(c) le stockage (S3, S5), par le BMS, d'une première tension de banc du banc de batteries cible avant la décharge du banc de batteries cible et d'une seconde tension de banc du banc de batteries cible après la décharge du banc de batteries cible ;

(d) le fait de dériver (S6), par le BMS, une variation de tension courante ($\Delta V_{current}$) sur la base de la première tension de banc et de la seconde tension de banc ;

(f) l'estimation (S7), par le BMS, d'un degré de dégradation de résistance par rapport au banc de batteries cible sur la base d'une variation de tension de référence ($\Delta V_{reference}$) du banc de batteries cible et de la variation de tension courante ($\Delta V_{current}$) ;

(g) la répétition des étapes (a) à (f) pour chaque banc de batteries (101, ..., 103) ; et

(h) le diagnostic (S8), par le BMS, de la pluralité de bancs de batteries (101, ..., 103) sur la base du degré de dégradation de résistance par rapport à chacun de la pluralité de bancs de batteries (101, ..., 103),

dans lequel les conditions de décharge comprennent au moins un parmi une tension de banc, une température de banc, et un temps de repos de chacun de la pluralité de bancs de batteries ;

**caractérisé en ce que** le diagnostic de la pluralité de bancs de batteries (101, ..., 103) comprend :

le fait de dériver, par le BMS, une valeur représentative entière d'une pluralité de degrés de dégradation de résistance sur la base de la pluralité de degrés de dégradation de résistance par rapport à la pluralité de bancs de batteries (101, ..., 103) ;

le calcul, par le BMS, d'un facteur d'idéalité multi-parallèle en tant que rapport entre le nombre de connexions parallèles dans le banc de batteries et le nombre de connexions parallèles moins une ;

le calcul, par le BMS, d'une valeur de seuil limite supérieure d'une plage normale en multipliant la valeur représentative entière de la pluralité de degrés de dégradation de résistance par le facteur d'idéalité multi-parallèle ; et

le fait de dériver, par le BMS, la plage normale sur la base de la valeur de seuil limite supérieure, et le diagnostic d'un état de chacun de la pluralité de bancs de batteries (101, ..., 103) selon la plage normale.

2. Procédé selon la revendication 1, dans lequel la variation de tension de référence ($\Delta V_{reference}$) du banc de batteries cible est une variation de tension initiale stockée dans le BMS par rapport au banc de batteries cible, et

dans lequel la variation de tension initiale est une variation de tension avant et après une première décharge de chacun de la pluralité de bancs de batteries (101, ..., 103).

3. Procédé selon la revendication 1, dans lequel le calcul de la valeur de seuil limite supérieure comprend :

la définition, par le BMS, en tant que groupe cible, d'une pluralité de premiers bancs de batteries ayant un degré de dégradation de résistance inférieur ou égal à la valeur représentative entière de la pluralité de degrés de dégradation de résistance parmi la pluralité de bancs de batteries (101, ..., 103) ;

le fait de dériver, par le BMS, une valeur représentative cible d'une pluralité de degrés de dégradation de résistance de la pluralité de premiers bancs de batteries appartenant au groupe cible ; et

le calcul de la valeur de seuil limite supérieure de la plage normale sur la base de la valeur représentative cible et du facteur d'idéalité multi-parallèle.

4. Procédé selon la revendication 1, dans lequel le diagnostic de l'état de chacun de la pluralité de bancs de batteries (101, ..., 103) comprend :

le fait de déterminer, par le BMS, un banc de batteries ayant un degré de dégradation de résistance égal ou inférieur à la valeur de seuil limite supérieure en tant qu'état normal parmi la pluralité de bancs de batteries (101, ..., 103) ; et

le fait de déterminer, par le BMS, un banc de batteries ayant un degré de dégradation de résistance plus grand que la valeur de seuil limite supérieure en tant qu'état anormal parmi la pluralité de bancs de batteries (101, ..., 103).

5. Système de batterie comprenant :

une pluralité de bancs de batteries (101, ..., 103) dans chacun desquels une pluralité d'éléments de batterie (11, ..., 16) sont connectés en parallèle ;

un circuit de décharge (30) connecté en parallèle entre une électrode positive et une électrode négative de chacun de la pluralité de bancs de batteries (101, ..., 103) et configuré pour décharger chacun de la pluralité de bancs de batteries (101, ..., 103) ; et

un système de gestion de la batterie (BMS) configuré pour :

(a) déterminer (S2) s'il y a un banc de batteries cible satisfaisant à des conditions de décharge parmi la pluralité de bancs de batteries (101, ..., 103) ;

(b) décharger (S4) le banc de batteries cible détecté par l'intermédiaire de la détermination par le circuit de décharge (30) ;

(c) stocker (S3, S5) une première tension de banc du banc de batteries cible avant de décharger le banc de batteries cible et une seconde tension de banc du banc de batteries cible après avoir déchargé le banc de batteries cible ;

(d) dériver (S6) une variation de tension courante ($\Delta V_{current}$) sur la base de la première tension de banc et de la seconde tension de banc ;

(e) estimer (S7) un degré de dégradation de résistance par rapport au banc de batteries cible sur la base d'une variation de tension de référence ($\Delta V_{reference}$) du banc de batteries cible et de la variation de tension courante ($\Delta V_{current}$) ;

(g) répéter les étapes (a) à (f) pour chaque banc de batteries ; et

(h) diagnostiquer la pluralité de bancs de batteries (101, ..., 103) ; sur la base du degré de dégradation de résistance par rapport à chacun de la pluralité de bancs de batteries (101, ..., 103) ;

dans lequel les conditions de décharge comprennent au moins un parmi une tension de banc, une température de banc, et un temps de repos de chacun de la pluralité de bancs de batteries ;

**caractérisé en ce que** le BMS est configuré pour :

dériver une valeur représentative entière d'une pluralité de degrés de dégradation de résistance sur la base de la pluralité de degrés de dégradation de résistance par rapport à la pluralité de bancs de batteries (101, ..., 103) ;

calculer un facteur d'idéalité multi-parallèle en tant que rapport entre le nombre de connexions parallèles dans le banc de batteries et le nombre de connexions parallèles moins une ;

calculer une valeur de seuil limite supérieure d'une plage normale en multipliant la valeur représentative entière de la pluralité de degrés de dégradation de résistance par le facteur d'idéalité multi-parallèle ; et

dériver la plage normale sur la base de la valeur de seuil limite supérieure, et diagnostiquer un état de chacun de la pluralité de bancs de batteries (101, ..., 103) selon la plage normale.

6. Système de batterie selon la revendication 5, dans lequel la variation de tension de référence ($\Delta V_{reference}$) du banc de batteries cible est une variation de tension initiale stockée dans le BMS par rapport au banc de batteries cible, et dans lequel la variation de tension initiale est une variation de tension avant et après une première décharge de chacun de la pluralité de bancs de batteries.

7. Système de batterie selon la revendication 6, dans lequel le BMS est configuré pour :

déterminer un banc de batteries ayant un degré de dégradation de résistance égal ou inférieur à la valeur de seuil limite supérieure du degré de dégradation de résistance en tant qu'état normal parmi la pluralité de bancs de batteries (101, ..., 103) ; et

déterminer un banc de batteries ayant un degré de dégradation de résistance plus grand que la valeur de seuil limite supérieure du degré de dégradation de résistance en tant qu'état anormal parmi la pluralité de bancs de batteries (101, ..., 103).

8. Système de batterie selon la revendication 7, dans lequel le BMS est configuré pour diagnostiquer un état de la pluralité de bancs de batteries (101, ..., 103) en distinguant si chacun de la pluralité de bancs de batteries (101, ..., 103) est dans l'état anormal.

【FIGURE 1】

【FIGURE 2】

```
┌─────────────────────────────────────────────────────────────────────────┐
│ PLURALITY OF REFERENCE VOLTAGE VARIATIONS  RESPECTIVELY WITH RESPECT TO    │─S1
│ PLURALITY OF BATTERY BANKS ARE PREVIOUSLY STORED                          │
└─────────────────────────────────────────────────────────────────────────┘
```

S2
IS THERE BATTERY
BANK HAVING BANK VOLTAGE, BANK
TEMPERATURE, AND REST TIME SATISFYING DISCHARGE ⟶ No
CONDITIONS OF BATTERY BANK AMONG
PLURALITY OF BATTERY
BANKS?

Yes

```
┌─────────────────────────────────────────────────────────────────────────┐
│ STORE BANK VOLTAGE OF TARGET BATTERY BANK SATISFYING DISCHARGE CONDITION   │─S3
│ AS FIRST VOLTAGE INDICATING VOLTAGE OF BATTERY BANK BEFORE DISCHARGING     │
└─────────────────────────────────────────────────────────────────────────┘
```

```
┌─────────────────────────────────────────────────────────────────────────┐
│ TURN ON DISCHARGE SWITCH THROUGH SWITCH CONTROL SIGNAL AND DISCHARGE       │─S4
│ TARGET BATTERY BANK FOR PREDETERMINED TIME                                 │
└─────────────────────────────────────────────────────────────────────────┘
```

```
┌─────────────────────────────────────────────────────────────────────────┐
│ STORE BANK VOLTAGE OF TARGET BATTERY BANK AS SECOND VOLTAGE INDICATING     │─S5
│ VOLTAGE OF BATTERY BANK AFTER DISCHARGING                                  │
└─────────────────────────────────────────────────────────────────────────┘
```

```
┌─────────────────────────────────────────────────────────────────────────┐
│ DERIVE CURRENT VOLTAGE VARIATION INDICATING VARIATION OF BANK VOLTAGE      │─S6
│ DUE TO DISCHARGING OF TARGET BATTERY BANK BASED ON FIRST VOLTAGE           │
│ AND SECOND VOLTAGE                                                         │
└─────────────────────────────────────────────────────────────────────────┘
```

```
┌─────────────────────────────────────────────────────────────────────────┐
│ ESTIMATE DEGREE OF RESISTANCE DEGRADATION OF TARGET BATTERY BANK BASED     │─S7
│ ON REFERENCE VOLTAGE VARIATION AND CURRENT VOLTAGE VARIATION               │
└─────────────────────────────────────────────────────────────────────────┘
```

```
┌─────────────────────────────────────────────────────────────────────────┐
│ DIAGNOSE PLURALITY OF BATTERY BANKS INCLUDED IN BATTERY PACK BASED         │─S8
│ ON PLURALITY OF DEGREES OF RESISTANCE DEGRADATION RESPECTIVELY WITH        │
│ RESPECT TO PLURALITY OF BATTERY BANKS                                      │
└─────────────────────────────────────────────────────────────────────────┘
```

【FIGURE 3】

(a) SCS1 — High / Low — OFF / ON / OFF — TIME

(b) VB1 — V1 / $\triangle V_{CURRENT}$ / V2 — TIME

(c) IB — 0A / $I_{dis}$ — Rest / BANK DISCHARGE / Rest — t1 / t2 — TIME

【FIGURE 4】

DERIVE ENTIRE REPRESENTATIVE VALUE OF DEGREES OF RESISTANCE DEGRADATION BASED ON PLURALITY OF DEGREES OF RESISTANCE DEGRADATION RESPECTIVELY WITH RESPECT TO PLURALITY OF BATTERY BANKS ~S81

CALCULATE MULTI-PARALLEL IDEALITY FACTOR BASED ON NUMBER OF PARALLEL CONNECTIONS OF PLURALITY OF BATTERY BANKS ~S82

CALCULATE UPPER LIMIT THRESHOLD VALUE OF NORMAL RANGE BASED ON ENTIRE REPRESENTATIVE VALUE OF DEGREES OF RESISTANCE DEGRADATION AND MULTI-PARALLEL IDEALITY FACTOR ~S83

DERIVE NORMAL RANGE BASED ON UPPER LIMIT THRESHOLD VALUE, AND DIAGNOSE STATE OF EACH OF PLURALITY OF BATTERY BANKS ACCORDING TO NORMAL RANGE ~S84

**EP 4 318 008 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210149028
- JP 4606846 B
- JP 2006138750 B